# EUROPEAN PATENT APPLICATION

(11) **EP 2 093 309 A2**
(43) Date of publication of application: **26.08.2009**
(21) Application number: 09150378.9
(22) Date of filing: 12.01.2009
(51) Int. Cl.: C23C 24/08

(54) **Stabilized metal nanoparticles and methods for depositing conductive features using stabilized metal nanoparticles**

(30) Priority: 14.01.2008 US 13539
(71) Applicant: Xerox Corporation, Rochester, New York 14644 (US)
(72) Inventor: Li, Yuning, 128044, Singapore (SG); Wu, Yiliang, Mississauga Ontario L5M 7K3 (CA); Pan, Hualong, Ottawa Ontario K1J 7N4 (CA); Liu, Ping, Mississauga Ontario L5M 3H2 (CA); Smith, Paul F., Oakville Ontario L6J 2G2 (CA); Mahabadi, Hadi K., Mississauga Ontario L5K 2L1 (CA)
(74) Representative: Grünecker, Kinkeldey, Stockmair & Schwanhäusser Anwaltssozietät

(57) **Abstract**

A metal nanoparticle composition includes a thermally decomposable or UV decomposable stabilizer. A method of forming conductive features on a substrate, includes providing a solution containing metal nanoparticles with a stabilizer; and liquid depositing the solution onto the substrate, wherein during the deposition or following the deposition of the solution onto the substrate, decomposing and removing the stabilizer, by thermal treatment or by UV treatment, at a temperature below about 180 °C to form conductive features on the substrate.

## Description

### BACKGROUND

Fabrication of electronic circuit elements using liquid deposition techniques is of profound interest as such techniques provide potentially low-cost alternatives to conventional mainstream amorphous silicon technologies for electronic applications such as thin-film transistors (TFTs), light-emitting diodes (LEDs), RFID tags, photovoltaics, etc. However the deposition and/or patterning of functional electrodes, pixel pads, and traces, lines and tracks which meet the conductivity, processing, and cost requirements for practical applications have been a great challenge.

Solution-processable conductors are of great interest for printed electronic applications as electrodes, conducting lines in thin-film transistors, RFID tags, photovoltaics, etc. Metal nanoparticle-based inks represent a promising class of materials for printed electronics. However, most metal nanoparticles require large molecular weight stabilizers to ensure proper solubility and stability. These large molecular weight stabilizers inevitably raise the annealing temperatures of the metal nanoparticles above 200 °C in order to burn off the stabilizers, which temperatures are incompatible with most plastic substrates and can cause damage thereto.

Further, the use of lower molecular weight stabilizers can also be problematic, as smaller size stabilizers often do not provide desired solubility and often fail to effectively prevent coalescence an/or aggregation of the metal nanoparticles before use.

One of the advantages achieved by embodiments herein is that the metal nanoparticles stabilized with a thermally decomposable stabilizer or an ultraviolet (UV) decomposable stabilizer can be liquid deposited onto a substrate. The thermally decomposable or UV decomposable stabilizer molecules can then be decomposed into low molecular weight fragments by 1) heating to a temperature at or below 180 °C or 2) UV irradiation. As a result, a stable, metal nanoparticles solution is obtained, and also the post-deposition thermal annealing can be carried out at a low temperature such as, for example, at or below 180 °C, which is especially suitable for forming conductive patterns on plastic substrates.

### SUMMARY

Disclosed generally are metal nanoparticle compositions, and methods of making the same, that are stabilized with stabilizers enabling the composition to be thermally annealed at a low temperature, for example, below about 180 °C, and thus that can be used to form metal features on a wider range of substrates.

In embodiments, described is a metal nanoparticle composition comprised of metal nanoparticles stabilized with a thermally decomposable stabilizer or UV decomposable stabilizer.

In further embodiments, described is a method of forming conductive features on a substrate, the method comprising: providing a solution containing metal nanoparticles with a stabilizer; and liquid depositing the solution onto the substrate, wherein during the deposition or following the deposition of the solution onto the substrate, removing the stabilizer, by thermal treatment or by UV treatment, at a temperature below about 180 °C to form conductive features on the substrate. In a further embodiment the stabilizer is ultraviolet (UV) decomposable by UV radiation and wherein the stabilizer is decomposed by exposing the UV decomposable stabilizer to ultraviolet radiation to form low molecular weight fragments that are removed by heating at a temperature of below about 180 °C.
In a further embodiment the low molecular weight fragments have a lower molecular weight than the UV decomposable stabilizer.
In a further embodiment the UV decomposable stabilizer is represented by the formula Xₙ-Z,
wherein X is a functional group selected from the group consisting of a thiol, amine, carboxylic acid, -OH (alcohol), -C₅H₄N (pyridyl), -OC(=S)SH (xanthic acid), R'R"P- and R'R"P(=O)-, wherein R' and R'' are each individually a hydrocarbon group having from 1 to about 20 carbon atoms, and combinations thereof,
wherein n is the number of X groups from about 1 to about 5000, and
wherein Z is a UV decomposable functionality having more than about 20 carbon atoms and is a moiety that is cleaved photolytically under ultraviolet radiation.
In a further embodiment Z is a UV decomposable functionality of a disilane or polysilane having more than about 20 carbon atoms and is a moiety that is cleaved photolytically with ultraviolet radiation.
In a further embodiment the liquid depositing is selected from the group consisting of spin coating, blade coating, rod coating, dip coating, lithography or offset printing, gravure, flexography, screen printing, stencil printing, inkjet printing, and stamping.

In still further embodiments, described is a method of forming conductive features on a substrate, the method comprising: providing a solution containing metal nanoparticles with a thermally decomposable or UV decomposable stabilizer, liquid depositing the solution onto the substrate, forming the low molecular weight fragments by thermally treating the thermally decomposable stabilizer or exposing the UV decomposable stabilizer to ultraviolet radiation, and wherein during or after forming the low molecular weight fragments, further heating the substrate to a temperature of about 180 °C or less to facilitate removal of the low molecular weight fragments.
In a further embodiment the thermally decomposable stabilizer is heated to a temperature of from about 80 °C to about 180 °C in order to decompose the thermally decomposable stabilizer into low molecular weight fragments having a lower molecular weight than the thermally decomposable stabilizer.
In a further embodiment the UV decomposable stabilizer is represented by the formula Xₙ-Z,
wherein X is a functional group selected from the group consisting of a thiol, amine, carboxylic acid, -OH (alcohol), -C₅H₄N (pyridyl), -OC(=S)SH (xanthic acid), R'R"P- and R'R"P(=O)-, wherein R' and R'' are each individually a hydrocarbon group having from 1 to about 20 carbon atoms, and combinations thereof,
wherein n is the number of X groups from 1 to about 5000, and
wherein Z is a UV decomposable functionality having more than about 20 carbon atoms and is a moiety that is cleaved photolytically under ultraviolet radiation.
In a further embodiment Z is a UV decomposable functionality of a disilane or polysilane having more than about 20 carbon atoms and is a moiety that is cleaved photolytically under ultraviolet radiation.
In a further embodiment the UV decomposable stabilizer is exposed to ultraviolet radiation to form the low molecular weight fragments, wherein the low molecular weight fragments have a lower molecular weight than the UV decomposable stabilizer. In a further embodiment the liquid depositing is selected from the group consisting of spin coating, blade coating, rod coating, dip coating, lithography or offset printing, gravure, flexography, screen printing, stencil printing, inkjet printing, and stamping.

### EMBODIMENTS

Described is a method of forming conductive features on a substrate wherein a stabilized metal nanoparticle solution is liquid deposited onto a substrate. The stabilizer used to stabilize the metal nanoparticles is subsequently removed at a temperature below about 180 °C.

The metal nanoparticle solution herein includes a metal nanoparticle in a liquid system. In embodiments, the metal nanoparticles are composed of (i) one or more metals or (ii) one or more metal composites. Suitable metals may include, for example, Al, Ag, Au, Pt, Pd, Cu, Co, Cr, In, and Ni, particularly the transition metals, for example, Ag, Au, Pt, Pd, Cu, Cr, Ni, and mixtures thereof Silver may be used as a suitable metal. Suitable metal composites may include Au-Ag, Ag-Cu, Ag-Ni, Au-Cu, Au-Ni, Au-Ag-Cu, and Au-Ag-Pd. The metal composites may include non-metals, such as, for example, Si, C, and Ge. The various components of the metal composite may be present in an amount ranging for example from about 0.01 % to about 99.9% by weight, particularly from about 10% to about 90% by weight. In embodiments, the metal composite is a metal alloy composed of silver and one, two or more other metals, with silver comprising for example at least about 20% of the nanoparticles by weight, particularly greater than about 50% of the nanoparticles by weight. Unless otherwise noted, the weight percentages recited herein for the components of the metal nanoparticles do not include the stabilizer.

The term "nano" as used in "metal nanoparticles" refers to, for example, a particle size of less than about 1,000 nm, such as from about 0.5 nm to about 1,000 nm, for example, from about 1 nm to about 800 nm, from about 1 nm to about 500 nm, from about 1 nm to about 100 nm or from about 1 nm to about 20 nm. The particle size refers to the average diameter of the metal nanoparticles, as determined by TEM (transmission electron microscopy) or other suitable method.

As the liquid system, any suitable liquid or solvent may be used for the metal nanoparticle solution, including, for example, organic solvents and water. The volume of the solvent in the metal nanoparticle solution is, for example, from about 10 weight percent to about 98 weight percent, from about 50 weight percent to about 90 weight percent and from about 60 weight percent to about 85 weight percent. For example, the liquid solvent may comprise water, an alcohol such as, for example, methanol, ethanol, propanol, butanol, pentanol, hexanol, heptanol, octanol; a hydrocarbon such as pentane, hexane, cyclohexane, heptane, octane, nonane, decane, undecane, dodecane, tridecane, tetradecane, toluene, benzene, xylene, mesitylene, tetrahydrofuran; chlorobenzene; dichlorobenzene; trichlorobenzene; nitrobenzene; cyanobenzene; acetonitrile; or mixtures thereof

One, two, three or more solvents may be used in the metal nanoparticle solution. In embodiments where two or more solvents are used, each solvent may be present at any suitable volume ratio or molar ratio such as for example from about 99(first solvent): (second solvent) to about 1 (first solvents):99(second solvent).

The concentration of metal in the metal nanoparticle solution may be, for example, from about, 2 weight percent to about 90 weight percent, from about 5 weight percent to about 80 weight percent, from about 10 weight percent to about 60 weight percent, or from about 15 weight percent to about 50 weight percent, of the metal nanoparticle solution.

The stabilizer as used herein and further described in embodiments are those stabilizers that may be removed at a temperature less than about 180 °C. The stabilizers may be removed by, for example, 1) treatment of the thermally decomposable stabilizer with thermal energy or 2) treatment of the ultraviolet radiation decomposable stabilizer with ultraviolet radiation.

The stabilizer preferentially associates with the external surface of the metal nanoparticle. By doing so, the metal nanoparticle is able to remain sufficiently stable in a dispersed solution, that is, remain suspended in the solution in a substantially homogeneously distributed manner, for a sufficient time, for example a time period (prior to liquid deposition) where there is minimal precipitation or aggregation of the nanoparticles, for example, at least about 3 hours, or from about 3 hours to about 1 month, from about 1 day to about 3 months, from about 1 day to about 6 months, from about 1 week to over 1 year. In this way, when liquid deposited, conductive features may be formed on the substrate.

Described in embodiments is a method of forming conductive features on a substrate, wherein the stabilizer in the metal nanoparticle solution is a thermally decomposable stabilizer. The thermally decomposable stabilizer is thermally treated to decompose the stabilizer into low molecular weight fragments that may then be readily removed during annealing at a temperature below about 180 °C.

In embodiments, the thermally decomposable stabilizer may be represented by the formula Xₙ-Y, wherein X is a functional group that stabilizes the metal nanoparticles, wherein n is the number of X groups from about 1 to about 5000, from about 1 to about 500, from about 1 to about 100 and from about 1 to about 10, and wherein Y is a thermally decomposable functionality having more than about 20 carbon atoms and is a hydrocarbon group containing a functionality such as, for example, a branched alkyl carboxylate, a Diels-Alder adduct of N-sulfinamide, furan, succinimide, or combinations thereof Examples of X may include a thiol, amine, carboxylic acid, -OH (alcohol), -C₅H₄N (pyridyl), -OC(=S)SH (xanthic acid), R'R"P- and R'R"P(=O)-, wherein R' and R'' is a hydrocarbon group having from 1 to about 40 carbon atoms, from about 2 to about 30 carbon atoms and from about 5 or to 25 carbon atoms.

Unless otherwise indicated, the phrase "hydrocarbon group" encompasses both unsubstituted hydrocarbon groups and substituted hydrocarbon groups. Unsubstituted hydrocarbon groups may be, for example, a straight chain alkyl group, a branched alkyl group, a cycloalkyl group, an aryl group, an alkylaryl group, and an arylalkyl group. Example alkyl groups may include, for example, methyl, ethyl, propyl, butyl, pentyl, hexyl, heptyl, octyl, nonyl, decyl, undecyl, dodecyl, tridecyl, tetradecyl, pentadecyl, cyclopentyl, cyclohexyl, cycloheptyl, and isomeric forms thereof Substituted hydrocarbon groups may be the unsubstituted hydrocarbon groups described herein which are substituted one, two or more times with, for example, a halogen (chlorine, bromine, fluorine, and iodine), nitro, cyano, an alkoxy group (methoxyl, ethoxyl, and propoxyl), or a mixture thereof In embodiments, the hydrocarbon group may be optionally substituted alkyl and optionally substituted aryl.

In embodiments, the thermally decomposable stabilizer may be heated to a temperature of from about 80 °C to about 180 °C, from about 100 °C to about 150 °C or from about 110 °C to about 140 °C to decompose the thermally decomposable stabilizer into low molecular weight fragments.

The low molecular weight fragments represent a thermally removable derivative of the thermally decomposable stabilizer. The lower molecular weight fragments have a lower molecular weight than the thermally decomposable stabilizer as the exposing of metal nanoparticles stabilized with a thermally decomposable stabilizer to a temperature of from about 80 °C to about 180 °C decomposes the thermally decomposable stabilizer into smaller size derivative or low molecular weight fragments. The low molecular weight fragments can have from about 2 to about 60 carbon atoms, such as, for example, from about 2 to about 50 carbon atoms or from about 2 to about 40 carbon atoms.

As illustrated below in Scheme 1, a thermally decomposable stabilizer containing Y groups such as a Diels-Alder adduct of N-sulfinamide, furan, or succimide, may be heated to undergo retro-Diels-Alder reaction and thus decompose the thermally decomposable stabilizer into lower molecular weight fragments. Further, a thermally decomposable stabilizer containing Y groups of branched alkyl carboxylates may be heated to undergo an elimination reaction and thus form lower molecular weight fragments such as small molecular weight alkenes and small molecular weight carboxylic acids.
1) Retro-Diels-Alder reaction 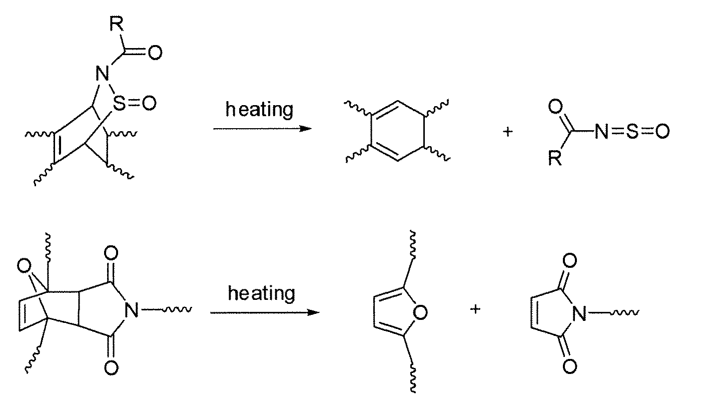
2) Decomposition of branched alkyl carboxylates

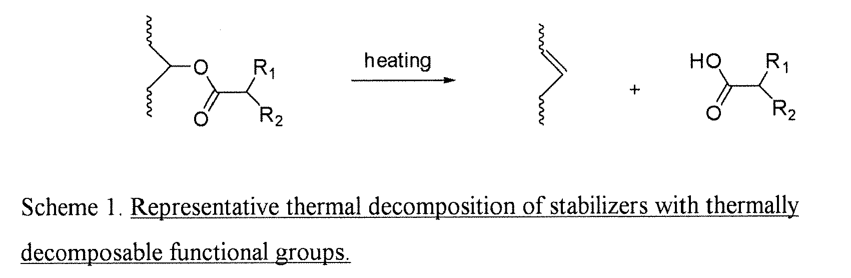

In still further embodiments is described a method of forming conductive features on substrate wherein the stabilizer in the metal nanoparticle solution is an ultraviolet (UV) decomposable stabilizer in which the stabilizer is decomposed by exposure to UV radiation at a temperature below about 180 °C.

The UV decomposable stabilizer can be represented by the formula Xₙ-Z, wherein X is a functional group selected from the group consisting of a thiol, amine, carboxylic acid, -OH (alcohol), -C₅H₄N (pyridyl), -OC(=S)SH (xanthic acid), R'R"P- and R'R''P(=O)-, wherein R' and R'' is a hydrocarbon group having from 1 to about 40 carbon atoms, from about 2 to about 30 carbon atoms and from about 5 or to 25 carbon atoms, wherein n is the number of X groups from about 1 to about 5000, from about 1 to about 500, from about 1 to about 100 and from about 1 to about 10, and wherein Z is a UV decomposable functionality having more than about 20 carbon atoms and is a moiety that is cleaved photolytically under ultraviolet radiation such as, for example, a disilane or polysilane (containing Si-Si linkages).

Scheme 2 illustrates a UV decomposable stabilizer with Z groups as Si-Si linkages that undergo photolysis when exposed to UV radiation. The Si-Si linkages, when exposed to UV radiation, decompose into lower molecular weight fragments that can be thermally removed at a temperature below about 180 °C.

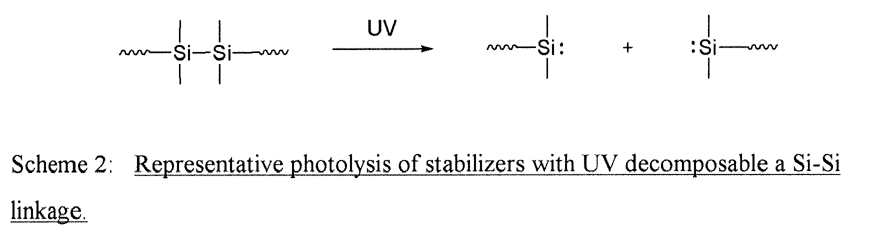

In embodiments, the UV decomposable stabilizer is exposed to ultraviolet radiation for about 1 millisecond to about 1 hour, about 1 second to about 10 minutes, about 5 seconds to about 5 minutes or about 10 seconds to about 1 minute.

The low molecular weight fragments represent a thermally removable derivative of the UV decomposable stabilizer. The lower molecular weight fragments have a lower molecular weight than the UV decomposable stabilizer as the exposing of a metal nanoparticle stabilized with a UV decomposable stabilizer to UV radiation decomposes the UV decomposable stabilizer into smaller size derivative or low molecular weight fragments. The low molecular weight fragments can have from about 2 to about carbon 60 atoms, such as, for example, from about 2 to about carbon 50 atoms or from about 2 to about 40 carbon atoms. The lower molecular weight fragments can be thermally removed at a temperature below about 180 °C.

In embodiments, the metal nanoparticles with thermally decomposable or UV decomposable stabilizer can be mixed with any other materials such as other metal nanoparticles, metal oxide nanoparticles, metal salts, insulating polymers, organic semiconductors, polymer semiconductors, conductive polymers, and the like and the mixtures thereof The weight percentage of metal nanoparticles in the mixture can be from about 1 weight percent to about 99 weight percent, from about 5 weight percent to about 90 weight percent, or from about 10 weight percent to about 80 weight percent.

The substrate may be composed of, for example, silicon, glass plate, plastic film or sheet. For structurally flexible devices, plastic substrate, such as, for example, polyester, polycarbonate, polyimide sheets and the like may be used. The thickness of the substrate may be from about 10 micrometers to about 10 millimeters, from about 50 micrometers to about 2 millimeters, especially for a flexible plastic substrate and from about 0.4 millimeters to about 10 millimeters for a rigid substrate such as glass or silicon.

In embodiments, heating the deposited composition of the metal nanoparticle to a temperature of, for example, below about 180 °C, at or below about 170 °C, or at or about below 150 °C, induces the metal nanoparticles to form an electrically conductive layer, which is suitable for use as an electrically conductive element in electronic devices. The heating temperature is one that does not cause adverse changes in the properties of previously deposited layer(s) or the substrate (whether single layer substrate or multilayer substrate). Also, the low heating temperatures described above allows the use of low cost plastic substrates, which may not withstand annealing temperature above about 200 °C.

As used herein, the term "heating" encompasses any technique(s) that can impart sufficient energy to the heated material to cause the desired result such as thermal heating (for example, a hot plate, an oven, and a burner), infra-red ("IR") radiation, microwave radiation, or a combination thereof

The heating can be performed for a time ranging from, for example, about 1 second to about 10 hours and from about 10 seconds to about 1 hour. The heating can be performed in air, in an inert atmosphere, for example, under nitrogen or argon, or in a reducing atmosphere, for example, under nitrogen containing from about 1 to about 20 percent by volume hydrogen. The heating can also be performed under normal atmospheric conditions or at a reduced pressure of, for example, from 1000 mbars to about 0.01 mbars.

The stabilized metal nanoparticles may be dispersed in any suitable dispersing solvent in forming a solution that may be liquid deposited and thus form metal features on a substrate. The weight percentage of stabilized metal nanoparticles in the dispersed solution may be from, for example, about 5 weight percent to about 80 weight percent, from about 10 weight percent to about 60 weight percent or from about 15 weight percent to about 50 weight percent. Examples of the dispersing solvent may include, for example, water, pentane, hexane, cyclohexane, heptane, octane, nonane, decane, undecane, dodecane, tridecane, tetradecane, toluene, xylene, mesitylene, and the like; alcohols such as, for example, methanol, ethanol, propanol, butanol, pentanol, hexanol, heptanol, octanol, and the like; tetrahydrofuran; chlorobenzene; dichlorobenzene; trichlorobenzene; nitrobenzene; cyanobenzene; acetonitrile; dichloromethane; N,N-dimethylformamide (DMF); and mixtures thereof One, two, three or more solvents may be used. In embodiments where two or more solvents are used, each solvent may be present at any suitable volume ratio or molar ratio such as for example from about 99(first solvent):1(second solvent) to about 1(first solvent):99(second solvent).

In embodiments, after heating, the resulting electrically conductive layer has a thickness ranging, for example, from about 5 nanometers to about 5 micrometers and from about 10 nanometers to about 1000 nanometers.

The conductivity of the resulting metal element produced by heating the deposited metal nanoparticle composition is, for example, more than about 100 Siemens/centimeter ("S/cm"), more than about 1000 S/cm, more than about 2,000 S/cm, more than about 5,000 S/cm, or more than about 10,000 S/cm.

The resulting conductive elements can be used as electrodes, conductive pads, thin-film transistors, conductive lines, conductive tracks, and the like in electronic devices such as thin-film transistors, organic light emitting diodes, RFID (radio frequency identification) tags, photovoltaic, and other electronic devices which require conductive elements or components.

The fabrication of an electrically conductive element from the metal nanoparticle composition ("composition") can be carried out by depositing the composition on a substrate using a liquid deposition technique at any suitable time prior to or subsequent to the formation of other optional layer or layers on the substrate. Thus, liquid deposition of the composition on the substrate can occur either on a substrate or on a substrate already containing layered material, for example, a semiconductor layer and/or an insulating layer.

The phrases "liquid deposition technique" or "liquid depositing" refer to, for example, the deposition of a composition using a liquid process such as liquid coating or printing, where the liquid is a solution or a dispersion. The metal nanoparticle composition may be referred to as an ink when printing is used. Examples of liquid coating processes may include, for example, spin coating, blade coating, rod coating, dip coating, and the like. Examples of printing techniques may include, for example, lithography or offset printing, gravure, flexography, screen printing, stencil printing, inkjet printing, stamping (such as microcontact printing), and the like. Liquid deposition deposits a layer of the composition having a thickness ranging from about 5 nanometers to about 5 micrometers, preferably from about 10 nanometers to about 1000 nanometers. The deposited metal nanoparticle composition at this stage may or may not exhibit appreciable electrical conductivity.

The stabilized metal nanoparticle can be spin-coated from the metal nanoparticles dispersed solution, for example, for about 10 seconds to about 1000 seconds, for about 50 seconds to about 500 seconds or from about 100 seconds to about 150 seconds, onto a substrate at a speed, for example, from about 100 revolutions per minute ("rpm") to about 5000 rpm, from about 500 rpm to about 3000 rpm and from about 500 rpm to about 2000 rpm.

EXAMPLE 1

Synthesis of silver nanoparticles stabilized with an adduct of furan-2-carboxylic acid/N-octylmaleimide

a. Synthesis of oleylamine-stabilized silver nanoparticles

Silver acetate (3.34 g, 20 mmol) and oleylamine (13.4 g, 50 mmol) are dissolved in 40 mL toluene and stirred at 55 °C for 5 minutes. Phenylhydrazine (1.19 g, 11 mmol) solution in toluene (10 mL) is added into above solution drop-wise with vigorous stirring. The resulting solution is stirred at 55 °C for 10 additional minutes and forms a precipitate when added drop-wise to a mixture of acetone/methanol (150 mL/150 mL). The precipitate of silver nanoparticles are filtered and washed briefly with acetone and methanol, yielding a gray solid.

b. Synthesis of silver nanoparticles stabilized with an adduct of furan-2-carboxylic acid/N-octylmaleimide

The silver nanoparticles as prepared above are dissolved in 50 mL of hexane and added drop-wise to a solution comprising an adduct of furan-2-carboxylic acid/N-octylmaleimide (prepared by the Diels-Alder reaction of furan-2-carboxylic acid and N-octylmaleimide) (16.07 g, 50 mmol) in hexane (50 mL) at room temperature. After 30 minutes, the hexane is removed and the residue is poured into a stirring methanol (200 mL). After filtration, washing with methanol, and drying (in vacuo), a gray solid is obtained.

Preparation of Silver Nanoparticles Solution (Dispersion)

The silver nanoparticles stabilized with an adduct of furan-2-carboxylic acid/N-octylmaleimide are dissolved in toluene to form a dispersed homogeneous solution. The total weight of the dispersed solution is 4 grams and the concentration of element silver is 1.25 mmol/g. Next, the dispersed solution is filtered using a 0.2 micron PTFE (polytetrafluoroethylene, Teflon) or glass filter.

Fabrication and Annealing of Thin Films of Silver Nanoparticles

The above dispersed solution is spin-coated on a glass substrate at a speed of 1000 rpm for 120 seconds. Next, a hotplate in air heats the substrate with a thin layer of silver nanoparticles to remove the furan-2-carboxylic acid/N-octylmaleimide stabilizer. A conductive silver film is then obtained after heating the substrate to a temperature of 150 °C for 30 minutes.

EXAMPLE 2

Synthesis of Amino Group-containing Polysilane Stabilized Silver Nanoparticles

Silver acetate (3.34 g, 20 mmol) and amino (NH₂) group-containing poly(dimethylsilane) (molecular weight = ∼1000; 50 g, 50 mmol) are dissolved in 40 mL toluene and stirred at 55 °C for 5 minutes. Phenylhydrazine (1.19 g, 11 mmol) solution in toluene (10 mL) is then added into above solution drop-wise with vigorous stirring. After stirring the resulting solution at 55 °C for 10 additional minutes, a precipitate is formed upon the addition of a mixture of acetone/methanol (150 mL/150 mL). The precipitate of silver nanoparticles are filtered and washed briefly with acetone and methanol, yielding a gray solid.

Preparation of Silver Nanoparticles Solution (Dispersion)

The silver nanoparticles stabilized with amino group-containing poly(dimethyl)silane are dissolved in toluene to form a dispersed homogeneous solution. The total weight of the dispersed solution is 4 grams and the concentration of element silver is 1.25 mmol/g. Next, the dispersed solution is filtered using a 0.2 micron PTFE (polytetrafluoroethylene, Teflon) or glass filter.

Fabrication, UV radiation and Annealing of Thin Films of Silver Nanoparticles

The above dispersed solution is spin-coated on a glass substrate at a speed of 1000 rpm for 120 seconds. Next, the substrate is placed under a UV lamp (254 nm) for 5 minutes. Then the substrate is heated on a hotplate in air to remove the by-products (low molecular weight fragments) from UV radiation. A conductive silver film is then obtained after heating the substrate to a temperature of 150 °C for 30 minutes.

It will be appreciated that various of the above-disclosed and other features and functions, or alternatives thereof, may be desirably combined into many other different systems or applications.

## Claims

1. A metal nanoparticle composition comprised of metal nanoparticles stabilized with a thermally decomposable stabilizer or UV decomposable stabilizer.

2. The metal nanoparticle composition according to claim 1, wherein the metal nanoparticles are selected from the group consisting of silver, gold, platinum, palladium, copper, cobalt, chromium, nickel, silver-copper composite, silver-gold-copper composite, gold-copper composite, silver-nickel composite, gold-nickel composite, gold-silver-copper composite, silver-gold-palladium composite and combinations thereof

3. The metal nanoparticle composition according to claim 1, wherein the thermally decomposable stabilizer is represented by the formula Xₙ-Y
wherein X is a functional group selected from the group consisting of a thiol, amine, carboxylic acid, -OH (alcohol), -C₅H₄N (pyridyl), -OC(=S)SH (xanthic acid), R'R"P- and R'R"P(=O)-, wherein R' and R" are each individually a hydrocarbon group having from 1 to about 20 carbon atoms, or combinations thereof,
wherein n is the number of X groups from 1 to about 5000, and
wherein Y is a thermally decomposable functionality having more than about 20 carbon atoms.

4. The metal nanoparticle composition according to claim 3, wherein Y is a hydrocarbon group containing a functionality selected from the group consisting of a branched alkyl carboxylate, a Diels-Alder adduct of N-sulfinamide, furan, or succinimide, or combinations thereof

5. The metal nanoparticle composition according to claim 1, wherein the UV decomposable stabilizer is represented by the formula Xₙ-Z,
wherein X is a functional group selected from the group consisting of a thiol, amine, carboxylic acid, -OH (alcohol), -C₅H₄N (pyridyl), -OC(=S)SH (xanthic acid), R'R"P- and R'R"P(=O)-, wherein R' and R'' are each individually a hydrocarbon group having from 1 to about 20 carbon atoms, and combinations thereof,
wherein n is the number of X groups from 1 to about 5000, and
wherein Z is a UV decomposable functionality having more than about 20 carbon atoms and is a moiety that is cleaved photolytically with ultraviolet radiation.

6. The metal nanoparticle composition according to claim 5, wherein Z is a UV decomposable functionality of a disilane or polysilane having more than about 20 carbon atoms and is a moiety that is cleaved photolytically under ultraviolet radiation.

7. The metal nanoparticle composition according to claim 1, wherein the method further comprises dispersing the metal nanoparticle composition in a solvent selected from the group consisting of water, pentane, hexane, cyclohexane, heptane, octane, nonane, decane, undecane, dodecane, tridecane, tetradecane, toluene, xylene, mesitylene, methanol, ethanol, propanol, butanol, pentanol, hexanol, heptanol, octanol, tetrahydrofuran, chlorobenzene, dichlorobenzene, trichlorobenzene, nitrobenzene, cyanobenzene, acetonitrile, dichloromethane, N,N-dimethylformamide (DMF) and combinations thereof

8. A method of forming conductive features on a substrate, the method comprising:
providing a solution containing metal nanoparticles with a stabilizer; and
liquid depositing the solution onto the substrate, wherein during the deposition or following the deposition of the solution onto the substrate, removing the stabilizer, by thermal treatment or by UV treatment, at a temperature below about 180 °C to form conductive features on the substrate.

9. The method according to claim 8, wherein the stabilizer is thermally decomposable and wherein the stabilizer is removed by thermally treating metal nanoparticles with a thermally decomposable stabilizer at a temperature of below about 180 °C.

10. The method according to claim 9, wherein the thermally decomposable stabilizer is represented by the formula Xₙ-Y,
wherein X is a functional group selected from the group consisting of a thiol, amine, carboxylic acid, -OH (alcohol), -C₅H₄N (pyridyl), -OC(=S)SH (xanthic acid), R'R"P- and R'R"P(=O)-, wherein R' and R'' are each individually a hydrocarbon group having from 1 to about 2carbon atoms, and combinations thereof,
wherein n is the number of X groups from 1 to about 5000, and
wherein Y is a thermally decomposable functionality having more than about 20 carbon atoms.

11. The method according to claim 10, wherein Y is a hydrocarbon group containing a functionality selected from the group consisting of a branched alkyl carboxylate, a Diels-Alder adduct of N-sulfinamide, furan, or succinimide, or combinations thereof

12. The method according to claim 8, wherein the conductive feature is heated to a temperature of from about 80 °C to about 180 °C in order to decompose the thermally decomposable stabilizer into low molecular weight fragments having a lower molecular weight than the thermally decomposable stabilizer.

13. A method of forming conductive features on a substrate, the method comprising:
providing a solution containing metal nanoparticles with a thermally decomposable or UV decomposable stabilizer,
liquid depositing the solution onto the substrate,
forming low molecular weight fragments by thermally treating a thermally decomposable stabilizer or exposing a UV decomposable stabilizer to ultraviolet radiation, and
wherein during or after forming the low molecular weight fragments, further heating the substrate to a temperature of about 180 °C or less to facilitate removal of the low molecular weight fragments.

14. The method according to claim 13, wherein the thermally decomposable stabilizer is represented by the formula Xₙ-Y,
wherein X is a functional group selected from the group consisting of a thiol, amine, carboxylic acid, -OH (alcohol), -C₅H₄N (pyridyl), -OC(=S)SH (xanthic acid), R'R"P- and R'R"P(=O)-, wherein R' and R'' are each individually a hydrocarbon group having from 1 to about 20 carbon atoms, and combinations thereof,
wherein n is the number of X groups from 1 to about 5000, and
wherein Y is a thermally decomposable functionality having more than about 20 carbon atoms.

15. The method according to claim 14, wherein Y is a hydrocarbon group containing a functionality selected from the group consisting of a branched alkyl carboxylate, a Diels-Alder adduct of N-sulfinamide, furan, or succinimide, or combinations thereof.
